# EUROPEAN PATENT SPECIFICATION

(11) **EP 4 469 846 B1**
(45) Date of publication and mention of the grant of the patent: **02.09.2026**
(21) Application number: 22702692.9
(22) Date of filing: 27.01.2022
(51) Int. Cl.: G02B 6/42

(54) **AN INTERFACE MODULE AND A COUPLING DEVICE**
SCHNITTSTELLENMODUL UND KOPPLUNGSVORRICHTUNG
MODULE D'INTERFACE ET DISPOSITIF DE COUPLAGE

(43) Date of publication of application: 04.12.2024
(73) Proprietor: Telefonaktiebolaget LM Ericsson (publ), 164 83 Stockholm (SE)
(72) Inventor: MOSTI, Sergio, 16152 GENOVA (IT); D'INCÀ, Claudio, 16152 GENOVA (IT); ASSALE, Marco, 16152 GENOVA (IT); PAPARELLA, Gianni, 16152 GENOVA (IT)
(74) Representative: Ericsson
(86) International application number: PCT/EP2022/051956
(87) International publication number: WO 2023/143722

(56) References cited:
- CN-A- 113 885 140
- US-A1- 2015 296 638
- US-A1- 2019 273 340
- US-B1- 7 224 582

## Description

### Technical field

The present disclosure relates to an interface module and a coupling device configured for the thermal management of components, such as electrical or optical connectors and transceivers.

### Background

In Radio Access nodes, optical transceiver modules are becoming more power demanding, for example, in order to provide for an increase of the bitrate and additional requested functions. Especially in very dense optical units, a special care must be taken to manage the thermal design for the heat dissipation in order to provide the requested node capacity bandwidth, in terms of number of transceivers located on the front face with respect to the unit space occupation inside a rack.

Currently 10G SFP+ DWDM transceivers show a power consumption of 1.5W. A current solution at 10G for a Fronthaul telecoms equipment located in one rack unit (44.45 mm thickness) is able to thermally manage the maximum possible number of front optical transceivers. A next generation DWDM SFP28 may show a power consumption of 2.5W, and the power consumption can increase further if the SFP28 includes a full tuneable laser or other functions such as wavelength auto-negotiation. At the same time, the rack space available (e.g. 1 rack unit in a "pizza box" format) should be able to host the maximum number of front interfaces (e.g. more than 42), in order to optimize space occupied inside the rack. It is useful to utilize the full space available on the front of the unit to place a maximum number of optical transceivers. In order to manage components with high heat outputs, a new and efficient way of thermal management would be advantageous.

One issue that has arisen in the development of such connector systems is the build-up of heat in and around the connector. This problem is particularly pronounced for active cable assemblies (i.e. connectors or cables having embedded circuitry to boost their performance or carry out additional functions). In order to address this problem, heat sinks have been used to dissipate the heat that builds up in the connector.

CN113885140A describes a heat conducting structure, a heat dissipation device and an electronic device, and belongs to the technical field of communication. The heat conduction structure includes: a mounting assembly for removably mounting the heat generating module therein; a window is arranged on the mounting component; a thermally conductive assembly having a protrusion, the protrusion being capable of protruding into the window; an elastic member for pressing the heat generating module into contact with the protrusion when the heat generating module is mounted into the mounting member.

US 2015/296638 describes a connector housing assembly having a housing, a plurality of compressible heal conducting members and a monolithic heat sink. The housing has a first direction corresponding lo a height direction of the housing. a second direction parallel to a heat generating module insertion direction, and a third direction perpendicular to the first direction and the second direction. The housing includes a plurality of module receiving ports positioned side by side in the third direction.

### Summary

The invention defines an interface module according to claim 1. Different embodiments are set out in the dependent claims.

### Brief description of the drawings

For a better understanding of examples of the present invention, and to show more clearly how the examples may be carried into effect, reference will now be made, by way of example only, to the following drawings in which:
Figure 1 is a drawing of a part of a conventional interface module;
Figures 2 and 3 are drawings of a coupling device according to embodiments of the disclosure;
Figure 4 show an interface module comprising the coupling device according to embodiments of the disclosure;
Figure 5 show an interface module and part of a main unit, comprising the coupling device according to embodiments of the disclosure;
Figure 6 shows a cross-section of an interface module and part of a main unit, comprising the coupling device according to embodiments of the disclosure;
Figure 7 shows a further embodiment of the coupling device and interface module according to embodiments of the disclosure;
Figure 8 shows the further embodiment of the coupling device according to embodiments of the disclosure;
Figure 9 shows cross-section of an interface module and a main unit, comprising the coupling device according to embodiments of the disclosure; and
Figure 10 shows a cross-section of an interface module and a main unit, comprising the coupling device, according to a further embodiments of the disclosure;

### Detailed description

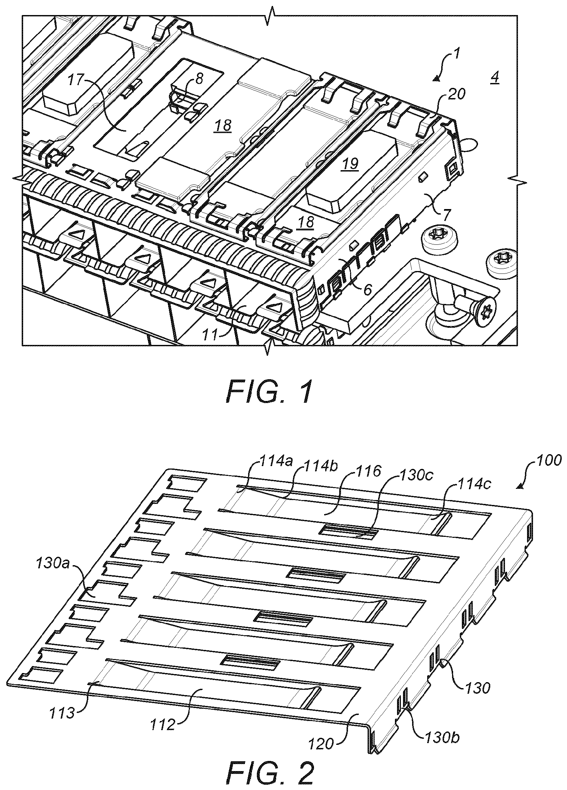

Figure 1 shows a conventional interface module 1, comprising a plurality of cages 6. The cages 6 have an opening 11 at a front end, a rear face at an end that is opposite to the opening, and a cage body 7 extending between the opening 11 and the rear face. An interface 8 is positioned within the cage, towards, adjacent or at the rear face of the cage. The interface 8 provides a connection to electronic circuitry, e.g. on a base or PCB 4. The interface 8 may possess a shape and structure that is complementary to a corresponding shape and structure of a connector (not shown).

The cage 6 is configured to receive a connector (e.g. a connector for a cable assembly, for example, an SFP), which can be inserted through the opening 11. The cage is configured to guide the connector towards the rear of the cage by the main body. The cage 6 may define an internal space or bore, having a cross section that complements the cross section of the connector, so as to guide the connector accurately to an interface 8 that is positioned within the cage 6. When the connector is fully inserted in the cage 6, the connector mates with the interface 8. This allows signals to pass from the connector to the PCB 4 via the interface 8, or from the PCB 4 to the connector via the interface 8.

The cage body 7 provides an open area 17, e.g. on a top side of the cage 6. In some examples, the open area 17 is a majority part of the top side of the cage 6. The open area 17 is an aperture in the cage 6 through which a coupling device of the present disclosure is configured to extend. In the conventional example shown in Figure 1, a SFP heatsink 18 is located over the open area 17. On top of the SFP heatsink 18, a thermal pad 19 is attached. The thermal pad is arranged to put the SFP heatsink in thermal connection with a main unit heatsink (not shown). A dedicated spring, or clip, 20 is used to hold the SFP heatsink in place. The main unit heat sink may be manufactured from a material having a high thermal conductivity, and comprise one or more fins or other features designed to dissipate heat.

Aspects of the present disclosure recognise that thermal management for optical components, e.g. a DWDM SFP, can be improved on standard open frame cages on which are anchored a heat sink through a dedicated spring/clip. The heatsink must be kept in position with a dedicated spring and so requires a manual operation for assembly of the unit. The thickness of the solution limits the height available for other components, e.g. heat dissipating fins on the main heat sink. The interface module may be suitable for use in a computerized or processing apparatus, such as a networked computer, server or a network node for a telecommunications network.

Aspects of the present disclosure provide for modified components providing for thermal dissipation of heat from a connector (e.g. SFP) to a heat sink of the interface module.

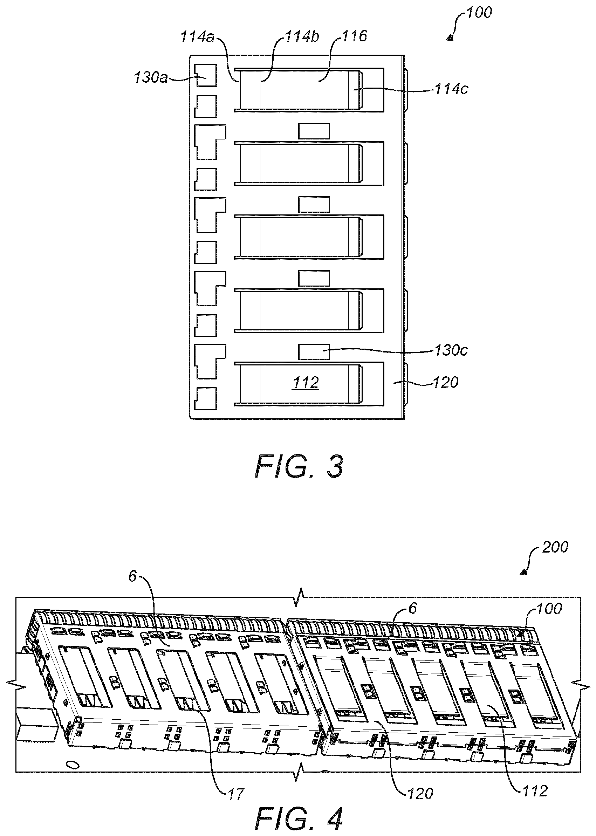

Figures 2, 3 and 4 show a coupling device 100 configured to provide for thermal coupling of a heat generating component (e.g. a connector or transceiver, e.g. in a SFP format) with a main unit heat sink. The coupling device 100 comprises one or more floating portions 112, e.g. a plurality of floating portions 112. The floating portions 112 are connected by a frame 120. The floating portions 112 are each arranged to locate over the open area 17 of a cage body 7. The coupling device 100 is configured to be used with a conventional cage 6 having the open area 17, as described above. In some aspects, the frame extends between and around the floating portions.

The one or more cages may be referred to as a set of cages 6. The unit, or interface module 200, may comprise one or more sets of cages 6. For example, the coupling device 100 may extend over only some of the cages in the interface module 200. In some examples, one or more additional coupling device 100 may extend over additional cages 6.

For each cage for which the coupling device 100 has a floating portion 112, the floating portion 112 is configured to move from a first position to a second position upon insertion of the signal connector into the cage. In the first position, the floating portion is not in thermal connection with the unit heat sink. In the second position, the floating portion is in thermal connection with the unit heat sink.

The frame 120 of the coupling device is securely attached to the set of cages, for example, using one or more mechanical fasteners 130. The one or more floating portion 112 are movable with respect to the frame 120, and hence also with respect to the cage body 7. In the illustrated embodiment, the floating portion 112 comprises a plate that is separated from the frame 120 along three edges thereof. At these three edges (e.g. two side edges and a third edge that is distal to the cage body opening), the floating portion is not coupled to the frame. At an edge 113 closest to the opening 11, the floating portion is coupled to the frame, such that the floating portion 112 acts as a flap and is able to move up and down relative to the cage body 7, i.e. into and out of the space defined by the cage 6 for receiving the connector.

In some examples, the frame 120 and floating portion 112 are integrally formed. For example, the coupling device is formed from a single piece of material, in which the frame 120 and floating portion 112 are formed. The frame 120 has a main surface formed as a plane, for example configured to extend over a plurality of cages. The one or more floating portion 112 extends out of the plane of the frame. In some examples, a plane of the floating portions 112 is parallel to the plane of the frame 120. The floating portion is shaped to extend into the volume defined by the cage body. This provides for an inserted connector to contact the floating portion, and push the floating portion towards the plane of the frame, e.g. upwardly, and towards the unit heat sink.

In some aspects, the floating portion is planar and configured to extend substantially parallel to the plane of the frame. For example, the floating portion 112 comprises a first bend 114a and a second bend 114b. The first bend 114a provides an angle between the plane of the frame 120 and the floating portion 112. The first bend 114a angles the floating portion into a position out of the plane of the frame 120, and into a volume of the cage through the open area 17. The second bend 114b angles the floating portion 112 such that a major part of the floating portion 112 extends parallel to the plane of the frame 120. In some aspects, the first bend 114a and/or second bend 114b is a boundary between the frame 120 and the floating portion. The major part of the floating portion 112 is also parallel to the plane of the cage and the connector inserted into the cage. The first bend 114a and second bend 114b are parallel to each other. The first bend 114a and second bend 114b are perpendicular to a longitudinal direction of the cage and/or an insertion direction of the connector. Alternatives to the first and second bend 114a, 114b comprise any shaping to locate the floating portion in the cage 6, e.g. a continuous S-shaped bend of the frame.

The first and second bends 114a, 114b provide for the floating portion 112 to have a large surface contact area 116 which is parallel to, and in contact with, the inserted connector when inserted. Thus, the shape of the floating portion provides for the floating portion to contact the connector over a large surface area, e.g. the whole width of the floating portion and more than 50% of its length.

In some examples, and optionally, the floating portion comprises a third bend 114c. The third bend 114c is located on the floating portion adjacent to an end which is distal to the first bend 114a. The third bend 114c is configured to angle the free end of the floating portion back towards the frame, i.e. in a direction out of the cage. In some examples, the free end of the floating portion is coincident with the plane of the frame 120. In some aspects, the angle of the free end of the floating portion, or upturn, provides for reliable removal of the connector from the cage. The angle of the free end of the floating portion presents a relatively smooth surface to a connector being removed, avoiding an edge within the cage volume which could catch on the connector.

In some examples, the floating portion 112 is connected to the frame with any number of bends which configure the floating portion to be out of the plane of the frame and located with the space of the cage to contact the connector. For example, the floating portion may comprise a single bend, which for example, may provide an angle to the floating portion in a single or two directions (e.g. a single S-shaped bend). In some aspects, the floating portion angled to the plane of the frame, e.g. is not parallel to the plane of the frame. In some aspects, the floating portion 11 does not comprise the third bend 114c. In some aspects, the floating portion is configured with a large contact area extending approximately the same distance below the frame. This means that, on contact with the connector, the whole contact area is moved towards the heat sink (e.g. upwardly) by approximately the same distance. This provides for a good contact and thermal connection between the connector and heat sink.

In some examples, the frame 120 and floating portion 112 are formed from the same sheet of material. The first bend 114a and the second bend 114b are created by bending the sheet of material, e.g. steel.

In some examples, the floating portion 112 provides a planar surface for contact with the connector. The floating portion 112 contacts the connector over a contact area 116, for example, between the second bend 114b and the third bend 114c, and over the whole width of the floating portion 112. In some examples, the contact area 116 is smooth, i.e. is not modulated with ridges. In some aspects, the floating portion 112 may be considered as U-shaped or finger shaped. In some examples, the floating portion 112 is attached to the frame 120 at one side, e.g. a front side adjacent to the opening in the cage for receiving a connector. The floating portion 112 is not attached to the frame at any other side, i.e. three sides of the rectangular floating portion 112 are not attached to the frame 120. In a further embodiment, the contact area 116 comprises slots or apertures. In some examples, the slots (e.g. elongate apertures) extend longitudinally, e.g. in the direction of insertion of the connector. The slots or apertures provide for deformation or bending of the contact area, to better conform to any irregularities on a contacting surface of the connector. In a further embodiment, the contact area 116 comprises ridges. The ridges are configured to protrude from the plane of the contact area 116, towards the connector. The ridges provide for a more reliable contact between the connector and the contact area 116.

In some aspects, the coupling device may be considered as a heat sink or be directly attached to a heat sink. For example, a thermally conductive part, e.g. made of metal, and functioning as a heat sink may be directly attached to the coupling device (e.g. to the contact area 116). In some examples, the thermally conductive part (e.g. heat sink) is configured to provide for efficient dissipation of heat, e.g. by comprising fins. In other aspects, the coupling device may be considered as a providing a thermal coupling between the connector and a heat sink, e.g. the unit heat sink.

The example described refers to the floating portion 112 as being located in an upper surface of the cage body. In some aspects, the floating portion may be located in a surface of the cage body adjacent to, parallel to, or facing, a heat sink (main heat sink). The module 200 may be orientated so that the surface in which the floating portion is located is facing vertically, horizontally (including down or up) or at an angle to vertical.

According to embodiments of the disclosure, a thermal pad is an example of a layer of thermal interface material on an outer surface of the floating portion 112. The thermal interface material is any material suitable for the transfer of thermal energy (i.e. a material having very high thermal conductivity). However, for reasons that will be apparent from the disclosure below, the thermal interface material should not have strong adhesive properties. Suitable materials for this purpose include thermal grease, thermal gap filler, or a thermal pad.

The coupling device 100 is configured to attach to the set of cages. For example, the frame comprises an attachment system configured to attach the coupling device to the set of cages. In some examples, the attachment system comprises one or more mechanical fasteners 130 to attach the coupling device to the set of cages. In some aspects, the attachment system releasably secures the coupling device in place, i.e. the coupling device is removable.

In some examples, the attachment system comprises one or more attachment elements 130 acting as engaging features on the coupling device and the set of cages. The engaging features may provide for locating the coupling device in the correct position, and/or, provide for securing the coupling device to the set of cages.

In the example shown, the coupling device comprises one or more first attachment elements 130a. The first attachment elements 130a are located on the frame 120, and configured to attach to the set of cages adjacent to the cage openings. The first attachment elements 130a are configured to attach to the set of cages 6 on a surface of the set of cages comprising the open area 17, e.g. top surface as shown.

In the example shown, the coupling device comprises one or more second attachment elements 130b. The second attachment elements 130b are located on the frame 120, and configured to attach to an end of the set of cages distal (i.e. opposite) to the cage openings. The second attachment elements 130b are configured to attach to the set of cages on an end wall of the set of cages, on a side surface opposite to the cage openings.

In the example shown, the coupling device comprises one or more third attachment elements 130c. The third attachment elements 130c are located on the frame 120, and configured to attach to a surface of the set of cages comprising the open areas 17. The second attachment elements 130b are located between the floating portions 112 overlying open areas 17 of adjacent cages.

In some aspects, the coupling device comprises a plurality of first, second and third attachment elements 130a, 130b, 130c. In some examples, the coupling device comprises one or more of the of first, second and third attachment elements 130a, 130b, 130c for each cage. In some examples, the coupling device does not comprise all of the first, second and third attachment elements 130a, 130b, 130c. For example, the coupling device only one or more the attachment elements 130, or may comprise additional or alternative attachment elements 130.

In the example shown, attachment elements 130 of the coupling device comprise one or more apertures in the frame. The set of cages comprise one or more protrusions, configured to engage with the apertures in the frame. Alternatively, any suitable fastening may be used, e.g. protrusions formed on the frame engaging features on the set of cages, or separate mechanical fasteners such as screws or rivets, or any other type of attachment means, e.g. adhesive.

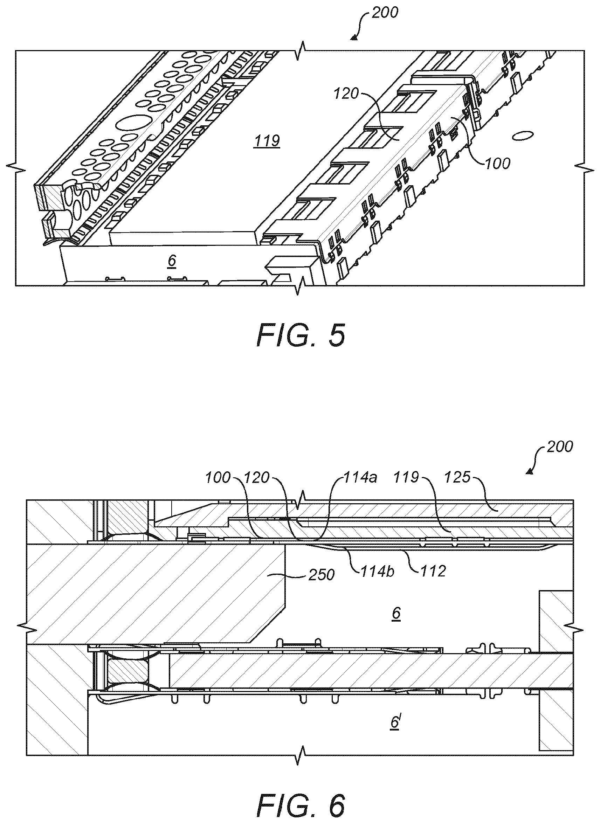

Figure 5 shows the set of cages 6 and attached coupling device 100. A thermal pad 119 is located on the coupling device 100. The thermal pad 119 is located on a top surface of the coupling device 100, i.e. on the opposite side of the coupling device to the set of cages. According to the claimed invention, the thermal pad 119 extends over a plurality of floating portions 112 and at least a part of the frame 120. As such, a single thermal pad 119 is used for a plurality of cages, i.e. in contact with a plurality of floating portions. The thermal pad 119 provides for a thermal connection from the floating portion to a main heat sink 125 (shown in Fig. 6). In some examples the thermal pad 119 contacts the main heat sink 125 when the connector is inserted. In some examples, the thermal pad 119 is compressible and maintains a thermal connection with the main heat sink when the floating portion is in the first position and second position. In this case, the solution may be defined by the floating portion moving from a first position inside the cage body to a second position, located outwardly from the first position, when the connector is inserted.

In some aspects, the thermal pad overlies the floating portions and is not affixed to the floating portions. When a cage receives a connector, and the floating portion is urged substantially out of the cage, the floating portion is urged into contact with the thermal pad 119. Alternatively, the thermal pad 119 is attached to the floating portions and/or frame. As such, the thermal pad 119 moves with the floating portion as the connector is inserted or removed from the cage. For example, the thermal pad is attached to the floating portion using adhesive.

The thermal connection between a said floating portion 112 and the heat sink 125 may be direct or via a thermal pad. Thus, thermal connection between a said floating portion and the heat sink includes meaning that the thermal connection is indirect, i.e. via an intermediary part such as the thermal pad and/or one or more further thermally conductive parts.

Figure 6 shows a connector 250 partially inserted into a cage 6. The connector shown is not inserted fully, and as such, is not in contact with the floating portion 112. Further insertion, i.e. movement to the right as shown, of the connector 250 will cause the connector 250 to contact the floating portion 112 extending into the cage. The angled surface of the floating portion, provided by the first bend 114a and second bend 114b, are configured to contact a leading edge of the connector. Movement of the connector 250 into the cage will urge the floating portion 112 substantially out of the cage, compressing the thermal pad and providing a good thermal contact between the floating portion 112 and the connector.

Upon insertion of a connector into the cage 6, however, the floating portion is urged upwards, out of or away from the internal volume of the cage 6. The floating portion 112 is urged out of the internal volume of the cage 6 by physical contact with the connector, i.e. as the connector is inserted. For example, if the cage defines an axis representing the direction of insertion of the connector (i.e. from the opening 11 to the interface 118), the floating portion 112 is urged in a direction away from the axis, e.g. substantially laterally away from the axis.

A further lower cage 6' is also shown, in an inverted configuration to the upper cage. The lower cage 6' has an open area (not shown) facing downwardly. The lower cage 6 is attached to a further coupling device (not shown), over the open area.

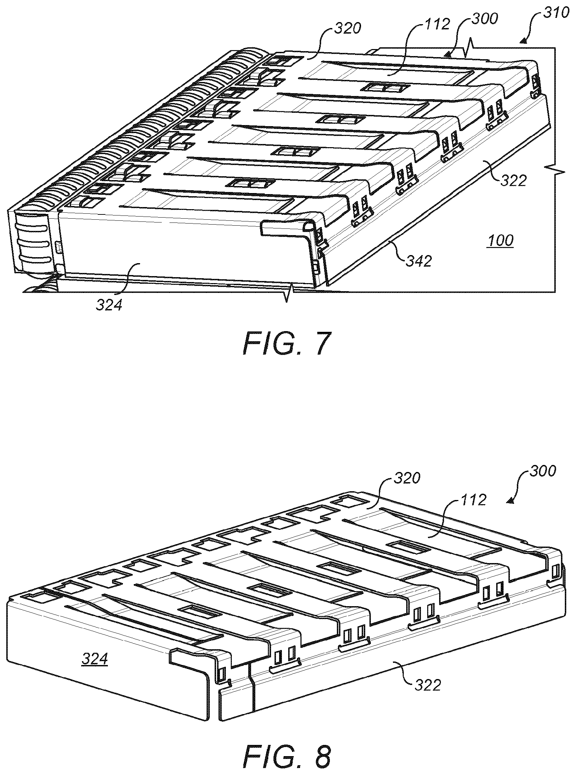

Figures 7 and 8 show an alternative embodiment of an interface module 310 comprising a coupling device 300. The coupling device 300 comprises a frame 320. The coupling device 300 further comprises a plurality of floating portions 112 as described above. The frame 320 is configured to provide for electromagnetic interference (EMI) shielding for the cages.

The frame 320 is configured to extend around the side surfaces of the set of cages. For example, the frame 320 comprises a rear part 322 extending over a rear surface of the set of cages, opposite to the cage openings. In addition, the frame 320 comprises side parts 324 extending over side surfaces of the set of cages, on lateral sides to the cage openings.

Further features of the coupling device 300 and frame 320 are as described with respect to the frame 100 and frame 120.

The rear part 322 and side parts 324 extend from the plane of the frame surrounding the floating portions 112 down to a base 340 on which the set of cages is attached. The base may comprise a printed circuit board (PCB). In some examples, an electroconductive gasket 342 connects or seals the rear part 322 and the side parts 324 to the base 340. In some aspects, the frame is connected to an electrical ground connection, e.g. through the electrically conductive gasket.

The frame 320 and rear part 322 and the side parts 324 are integrally formed, e.g. from a sheet steel material. The floating portion 112 is also integrally formed with the frame 320. The material of the coupling device is electrically conductive, e.g. comprises a metal or is entirely made of metal, e.g. steel. As such, the coupling device 100 provide for electromagnetic shielding for electromagnetic radiation from (or to) the connectors.

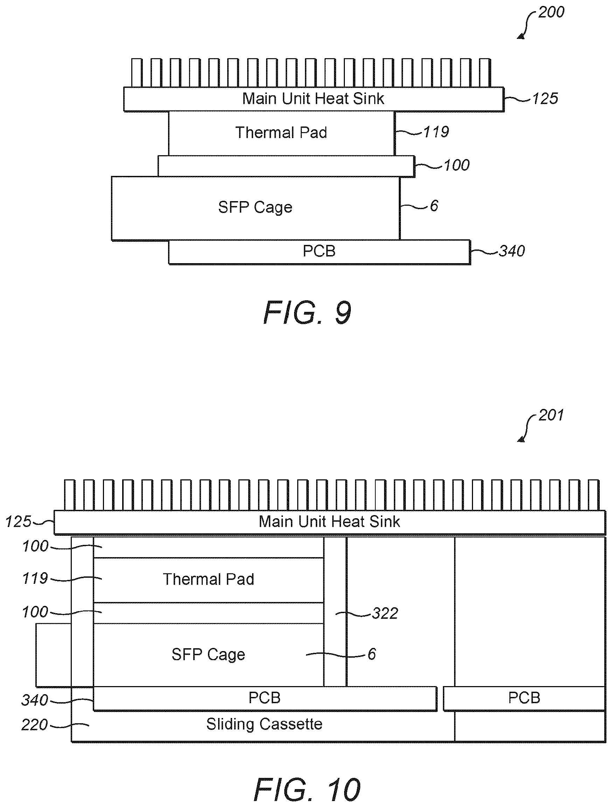

Figure 9 shows a schematic cross-section through the interface module 200 comprising a coupling device 100. The interface module 200 further comprises a cage 6, as an example of the set of cages, and is attached to a base 340 (e.g. a printed circuit board). The cage 6 is configured to receive a connector, e.g. SFP. The coupling device 100;300 is attached to the set of cages 6, on the opposite side to the base, e.g. over the open area 17 of the cage. The interface module 200 comprises a thermal pad 119 located between the coupling device and the main unit heat sink 125.

The coupling device provides a lower thermal resistance between the SFP and the main unit heat sink. The overall thickness for this solution allows a greater fin height for the main heat sink, since the coupling device provides for a low thickness for the thermal connection. The increased fin height of the main unit heat sink improves the thermal dissipation in a forced air condition.

Figure 10 shows a further embodiment of an interface module 201 comprising the coupling device 100;300 of any example. The interface module 201 is configured to be located in a sliding cassette 220, configured to slide into the main unit to engage with the main unit heat sink. The sliding cassette include a base 340, e.g. a printed circuit board. This embodiment comprises two of the described coupling devices. A first coupling device 100;300 is located as described above, located adjacent to an open area 17 of a set of cages 6. The interface module 201 comprises a thermal pad 119, located on top of the first coupling device, as described. In addition, a second coupling device 100;300 as described in any example is located on the thermal pad, on the opposite side to the first coupling device. The second coupling device is configured to form an outer surface of the sliding cassette, and so contact the main unit heat sink when the sliding cassette is connected to the main unit. In some examples, the floating portions and frames of the first and second coupling devices are aligned. In this example, the floating portion of the first coupling device enters into contact with the connector (e.g. SFP) while the floating element of the second smart heat sink enters into contact with the main heat sink. In some examples, the first and/or second coupling device comprises a rear part 322, and side part (not shown), to provide for reduced electromagnetic inference, as described above.

In some aspects, the cage and/or first coupling device and/or second coupling device has additional locking point to the base, to ensure robustness to the structure.

The described solutions allow use of standard and currently available connector (e.g. SFP) cages. Thus, the solution is compatible with existing connector (e.g. SFP) cages without the need to customize the set of cages.

The described solutions allow keeping the optical transceiver density on the front of a unit, even with higher power consumption connectors (e.g. transceivers or SFP) without increasing the unit thickness. As such, the unit can stay within 1 rack unit and/or allows the main unit heat sink to be larger, i.e. heat sink fin height increase. An improved thermal performance makes possible the use of higher power connectors (e.g. SFP28) and could allow the use of less powerful and less noisy fan trays also on existing units.

The described solutions avoid the use of the traditional connector (e.g. SFP) custom/standard heat sink with an associated spring, so less components are required with consistent thickness reduction, as well as a reduction in assembly labor. Thermal resistance is improved due to the geometry of the U-shaped metal with longitudinal cut that adapts to the connector top profile, limiting air gaps in between.

The described solutions provide for the thickness of the solution be smaller and allows to increase the height of the main heat sink fin increasing the allowing the use of less powerful fan trays with savings on the overall unit power consumption and noise

The described solutions allow the use of a single thermal pad for all connectors of the set of cages. The solution provides a high efficiency thermal management way for optical SFP, allowing a reduction in the cost of the mechanical parts in terms of the materials cost, and manual assembly labor cost, as well the overall unit power consumption. For example, the use of a single coupling device for a set of cages provides for improved assembly and cost of the parts. The single coupling device does not require separate clips to attach and/or the single coupling device is used for a plurality of cages/connectors. In some examples, the single coupling device for a plurality of connector cages comprises a plurality of floating portions, each independently providing a thermal connection for a connector.

The connector may form part of a cable assembly, comprising a cable with two plug connectors positioned at either end. The cable assembly may be configured to transfer optical or electrical signals to or from the interface module 200, and thus the interface and associated circuitry in the PCB may be configured to convert optical signals to corresponding electrical signals and vice versa, or to transfer electrical signals from the PCB to the connector and vice versa. The connector may take any form, including small form factor pluggable (SFP), quad SFP (QSFP), C form-factor pluggable (CFP) and XSP connectors.

The internal volume has a cross-sectional shape that complements the cross-sectional shape of the connector. Thus, the floating portion is pushed outwardly (that is, away from the direction of motion of the connector) by further insertion of the connector into the cage, against the biasing provided by the resilience of the material used in the coupling device.

When the connector is entirely inserted into the cage, the connector is coupled to the interface. The floating portion 112 is pushed outwards from the internal volume, such that the layer of thermal interface material (thermal pad) comes into thermal contact with the main unit heat sink. In this configuration, the connector is thus provided with a thermal interface which can then act as a heat sink for the heat that builds up in the connector during use. In some embodiments, a further layer of thermal interface material may be provided, such that the thermal pad comes into contact with the further layer of thermal interface material rather than the main unit heat sink directly.

Those skilled in the art will appreciate that the precise dimensions of the connector system described above, as well as the materials used, etc, may be varied so as to provide an optimal compromise between ease of use and thermal transfer efficiency.

The interface module 200 may comprise multiple PCBs and/or multiple cages or sets of cages. That is, a single PCB may be connected to one or more cages, and more than one PCB may be provided in a single interface module. A single main unit heat sink may be provided for multiple cages or multiple sets of cages. Alternatively, one or more separate main unit heat sinks may be provided for the cages.

In some examples, the interface module is for a computing apparatus (e.g. a computer, or server). In other embodiments, the apparatus may be any device that receives or transmits input or output signals (whether electric signals or optical signals), and thus has need of an input/output connector system. For example, the apparatus may be a node within a telecommunications network or radio access network, e.g. at a base station. In some examples, the apparatus comprises one or more, e.g. a plurality, of interface modules as described. The interface module provides one or more input/output connections to external devices or network components, via a cable assembly. Thus signals received via the interface module can be passed to a processor circuitry of the apparatus, e.g. for demodulation, and/or the processor circuitry can generate and transmit signals via the interface module.

Embodiments of the disclosure thus provide an efficient mechanism for the dissipation of heat in an input/output connector system. The set of cages of a connector system is provided with a coupling device having one or more floating portion that is movable, upon insertion of a connector into the cage, into engagement with a heat sink. The form of the coupling device provides for reliable assembly without requiring multiple components (such as separate coupling devices or spring clips, etc) to bring the connector and heat sink into thermal contact.

Aspects of the device relates to thermal management of optical transceivers for telecom equipment for Radio Access Networks, for example in fronthaul devices or backhaul devices, or any other node comprising optical transceivers.

The above disclosure sets forth specific details, such as particular embodiments or examples for purposes of explanation and not limitation. It will be appreciated by one skilled in the art that other examples may be employed apart from these specific details.

## Claims

1. An interface module, comprising:
a set of a plurality of cages (6), each cage configured to guide a signal connector towards an interface for connection with the signal connector;
wherein each cage (6) of the set of cages comprises an open area (17) facing a heat sink;
a coupling device (100) attached to the set of cages and extending over the open area of the cages,
wherein the coupling device comprises a floating portion (112) for each cage, wherein the floating portion (112) is configured to move from a first position to a second position upon insertion of the signal connector into the cage, wherein, when in the first position, the floating portion (112) is not in thermal connection with the heat sink, and wherein, when in the second position, the floating portion is in thermal connection with the heat sink;
**characterised in that** the interface module comprises a single thermal pad (119) configured to provide a thermal connection between a plurality of floating portions and the heat sink.

2. The interface module as claimed in claim 1, wherein the coupling device comprises a frame (120) extending over the set of cages, wherein the floating portion (112) for each cage is integrally formed with the frame.

3. The interface module according to any one of the preceding claims, wherein the frame comprises an attachment system configured to attach the coupling device to the set of cages.

4. The interface module according to any one of the preceding claims, wherein the coupling of the floating portion to the cage is an edge that is proximal to an opening of the cage through which the signal connector is insertable.

5. The interface module according to claim 4, wherein the floating portion comprises a first bend a second bend, wherein the first bend a second bend are configured to locate the floating portion within the volume of the cage.

6. The interface module according to any one of the preceding claims, wherein the signal connector consists of one of: an optical connector, an electrical connector, or an electro-optic connector.

7. The interface module according to any one of the preceding claims, wherein the signal connector consists of a small form-factor pluggable, SFP, connector.

8. The interface module according to claim 2, wherein the frame is configured to extend over one or more further sides of the set of cages to provide electromagnetic shielding.

## Patentansprüche

1. Schnittstellenmodul, umfassend:
einen Satz von Käfigen (6), wobei jeder Käfig dazu ausgelegt ist, einen Signalsteckverbinder zu einer Schnittstelle zur Verbindung mit dem Signalsteckverbinder zu führen;
wobei jeder Käfig (6) des Satzes von Käfigen einen offenen Bereich (17) aufweist, der einem Kühlkörper zugewandt ist;
eine Kopplungsvorrichtung (100), die an dem Satz von Käfigen befestigt ist und sich über den offenen Bereich der Käfige erstreckt,
wobei die Kopplungsvorrichtung einen schwebenden Abschnitt (112) für jeden Käfig umfasst, wobei der schwebende Abschnitt (112) dazu ausgelegt ist, sich bei Einführung des Signalsteckverbinders in den Käfig von einer ersten Position in eine zweite Position zu bewegen, wobei, wenn in der ersten Position, der schwebende Abschnitt (112) nicht in thermischer Verbindung mit dem Kühlkörper steht und wobei, wenn in der zweiten Position, der schwebende Abschnitt in thermischer Verbindung mit dem Kühlkörper steht;
**dadurch gekennzeichnet, dass** das Schnittstellenmodul ein einzelnes Wärmeleitpad (119) umfasst, das dazu ausgelegt ist, eine thermische Verbindung zwischen einer Mehrzahl von schwebenden Abschnitten und dem Kühlkörper bereitzustellen.

2. Schnittstellenmodul nach Anspruch 1, wobei die Kopplungsvorrichtung einen Rahmen (120) umfasst, der sich über den Satz von Käfigen erstreckt, wobei der schwebende Abschnitt (112) für jeden Käfig einstückig mit dem Rahmen ausgebildet ist.

3. Schnittstellenmodul nach einem der vorhergehenden Ansprüche, wobei der Rahmen ein Befestigungssystem umfasst, das dazu ausgelegt ist, die Kopplungsvorrichtung an dem Satz von Käfigen zu befestigen.

4. Schnittstellenmodul nach einem der vorhergehenden Ansprüche, wobei die Kopplung des schwebenden Abschnitts mit dem Käfig eine Kante ist, die proximal zu einer Öffnung des Käfigs ist, durch die der Signalsteckverbinder eingeführt werden kann.

5. Schnittstellenmodul nach Anspruch 4, wobei der schwebende Abschnitt eine erste Biegung und eine zweite Biegung aufweist, wobei die erste Biegung und die zweite Biegung dazu ausgelegt sind, den schwebenden Abschnitt innerhalb des Volumens des Käfigs zu positionieren.

6. Schnittstellenmodul nach einem der vorhergehenden Ansprüche, wobei der Signalsteckverbinder aus einem von Folgenden besteht: einem optischen Steckverbinder, einem elektrischen Steckverbinder oder einem elektrooptischen Steckverbinder.

7. Schnittstellenmodul nach einem der vorhergehenden Ansprüche, wobei der Signalsteckverbinder aus einem Small Form-Factor Pluggable-Steckverbinder, SFP-Steckverbinder, besteht.

8. Schnittstellenmodul nach Anspruch 2, wobei der Rahmen dazu ausgelegt ist, sich über eine oder mehrere weitere Seiten des Satzes von Käfigen zu erstrecken, um elektromagnetische Abschirmung bereitzustellen.

## Revendications

1. Module d'interface, comprenant :
un ensemble d'une pluralité de cages (6), chaque cage étant configurée pour guider un connecteur de signal vers une interface pour une connexion au connecteur de signal ;
dans lequel chaque cage (6) de l'ensemble de cages comprend une zone ouverte (17) faisant face à un dissipateur de chaleur ;
un dispositif de couplage (100) fixé à l'ensemble de cages et s'étendant sur la zone ouverte des cages,
dans lequel le dispositif de couplage comprend une partie flottante (112) pour chaque cage, dans lequel la partie flottante (112) est configurée pour se déplacer d'une première position à une deuxième position à l'insertion du connecteur de signal dans la cage, dans lequel, dans la première position, la partie flottante (112) n'est pas en connexion thermique avec le dissipateur de chaleur, et dans lequel, dans la deuxième position, la partie flottante est en connexion thermique avec le dissipateur de chaleur ;
**caractérisé en ce que** le module d'interface comprend un tampon thermique unique (119) configuré pour fournir une connexion thermique entre une pluralité de parties flottantes et le dissipateur de chaleur.

2. Module d'interface selon la revendication 1, dans lequel le dispositif de couplage comprend un cadre (120) s'étendant sur l'ensemble de cages, dans lequel la partie flottante (112) pour chaque cage est formée d'un seul tenant avec le cadre.

3. Module d'interface selon l'une quelconque des revendications précédentes, dans lequel le cadre comprend un système de fixation configuré pour fixer le dispositif de couplage à l'ensemble de cages.

4. Module d'interface selon l'une quelconque des revendications précédentes, dans lequel le couplage de la partie flottante à la cage est un bord qui est proximal d'une ouverture de la cage à travers laquelle le connecteur de signal peut être inséré.

5. Module d'interface selon la revendication 4, dans lequel la partie flottante comprend un premier coude et un deuxième coude, dans lequel le premier coude et le deuxième coude sont configurés pour localiser la partie flottante à l'intérieur du volume de la cage.

6. Module d'interface selon l'une quelconque des revendications précédentes, dans lequel le connecteur de signal consiste en l'un de : un connecteur optique, un connecteur électrique ou un connecteur électrooptique.

7. Module d'interface selon l'une quelconque des revendications précédentes, dans lequel le connecteur de signal consiste en un connecteur enfichable à faible encombrement, SFP.

8. Module d'interface selon la revendication 2, dans lequel le cadre est configuré pour s'étendre sur un ou plusieurs autres côtés de l'ensemble de cages pour fournir un blindage électromagnétique.
